# EUROPEAN PATENT APPLICATION

(11) **EP 4 815 036 A1**
(43) Date of publication of application: **30.09.2026**
(21) Application number: 25166111.2
(22) Date of filing: 25.03.2025
(51) Int. Cl.: H01L 25/07, H01L 23/36

(54) **POWER SEMICONDUCTOR MODULE AND ASSEMBLY METHOD**

(71) Applicant: Hitachi Energy Ltd, 8050 Zürich (CH)
(72) Inventor: Truessel, Dominik, 5620 Bremgarten (CH); Roesch, Andreas, 79730 Murg (DE); Santolaria, Lluis, 4600 Olten (CH); Fisher, Noam, 8001 Zürich (CH); Guillon, David, 8857 Vorderthal (CH)
(74) Representative: Michalski Hüttermann & Partner mbB

(57) **Abstract**

The invention relates to a power semiconductor module (1) and a method to assemble the module. The module comprises an electrically conducting base plate (110) and an electrically conducting top plate (120) arranged parallel, a plurality of power semiconductor devices (100) arranged on the base plate (110) facing the top plate (120), a plurality of electrical contacts (130) electrically connecting the plurality of semiconductor devices (100) in parallel, and a flat plate structure (140) mechanically and/or electrically interconnecting the electrical contacts (130), wherein each of the electrical contacts (130) comprises a presspin body (131) with a pin foot (1312) having a top surface (13121) abutting the flat plate structure (140) and a bottom surface (13122) facing the base plate (110), the top surface (13121) and/or the bottom surface (13122) of each pin foot (1312) has a convex spherical cap shape.

## Description

### Technical Field

The invention relates to the technical field of power modules, in particular, a power semiconductor module and a method for assembling the power semiconductor module.

### Background Art

Power semiconductor modules play a critical role in high-voltage, high-power applications, including motor drives, power converters and high-voltage direct current, HVDC, systems. These modules usually integrate multiple semiconductor devices, such as insulated-gate bipolar transistors, IGBTs, or metal-oxide-semiconductor field-effect transistors, MOSFETs, in a common package, enabling efficient and reliable power switching. In HVDC systems, these power semiconductor modules, especially power modules with pressure contacts, are typically arranged in a large stack to provide a serial connection of multiple power modules, ensuring efficient power conversion and transmission.

In addition to increased power requirements, modern high-voltage, high-power applications require Short Circuit Failure Mode, SCFM, capability. In case of a failure, a problematic semiconductor devices should be rendered conductive as a short circuit to sustain uninterrupted current flow, either for an extended period until scheduled maintenance can be conducted or for at least a few minutes until secondary protection mechanisms, such as a mechanical bypass, are activated. A higher SCFM current and a resulting high temperature therefore pose additional challenges for the power semiconductor modules.

Several power semiconductor module designs, especially power modules with pressure contacts, establish electrical connections between semiconductor devices and conductive plates through electrical contacts positioned perpendicularly to both. However, these traditional configurations face limitations in current-carrying capacity and heat dissipation due to the restricted cross-sectional area of the single electrical contact, particularly in SCFM conditions, where the complete short circuit current is carried by a single contact. As power demands increase, existing module designs struggle to support higher operational currents or withstand short-circuit currents exceeding 5,000 A.

A proposed improvement involves applying a distribution plate to electrically and thermally link the electrical contacts laterally, thereby equalizing current distribution across multiple terminals and enhancing heat dissipation. However, the rigidity of the distribution plate limits the semiconductor module's ability to accommodate mechanical tolerances caused by misalignments and tilts of components such as chips, metal preforms, or the distribution plate, as well as mismatch due to different thermal expansion coefficients. This results in uneven pressure distribution across the semiconductor chips, ultimately compromising the module's operational reliability and long-term performance with respect to thermal cycling.

An improved power semiconductor module is needed to provide enhanced current-carrying capacity and heat dissipation while improving the ability to compensate for mechanical tolerances.

### Summary of invention

It is therefore an object of the invention to provide a long-term reliable power semiconductor module with enhanced current-carrying capacity and heat dissipation, which is capable of compensating mechanical tolerances during assembly and/or mismatch dues to thermal expansion during operation.

The object of the invention is solved by the features of the independent claims. Preferred implementations are detailed in the dependent claims.

According to a first aspect of the invention, the object is solved by a power semiconductor module comprising:
an electrically conducting base plate and an electrically conducting top plate arranged parallel to each other,
a plurality of power semiconductor devices arranged on the base plate facing the top plate,
a plurality of electrical contacts electrically connecting the plurality of semiconductor devices in parallel, and
a flat plate structure mechanically and or electrically interconnecting the plurality of electrical contacts, wherein
each of the electrical contacts comprises a presspin body with a pin foot having a top surface abutting the flat plate structure and a bottom surface facing the base plate,
the top surface and or the bottom surface of each pin foot has a convex spherical cap shape.

In this context, electrically conducting means that the component is electrically conductive. The presspin body is electrically conductive. The plurality of electrical contacts may be arranged in a one-to-one correspondence with the plurality of semiconductor devices and provide an electrical connection between the semiconductor devices and the top plate. The semiconductor device may be a semiconductor chip. The flat plate structure may be sleeved on the presspin bodies of the plurality of electrical contacts.

Specifically, each of the plurality of electrical contacts may be arranged between the top plate and one of the plurality of semiconductor devices to establish electrical connections between the top plate and the plurality of semiconductor devices. In this embodiment, the bottom surfaces of the pin feet may face the plurality of semiconductor devices.

Alternatively, the bottom surfaces of the plurality of electrical contacts may abut and be connected to the base plate that is electrically connected to the plurality of the semiconductor devices. Alternatively, the bottom surfaces of the plurality of electrical contacts may abut and be connected to a metallization pattern to establish the parallel connection. The metallization pattern may be provided on an isolating layer made of resin or ceramic arranged on the base plate. The metallization pattern may be electrically connected to the plurality of semiconductor devices.

This combination of the flat plate structure and the pin feet with spherical cap surfaces ensures contact reliability and mechanical stability in terms of mechanical tolerances while improving the current-carrying and heat dissipation capabilities of the power semiconductor module. Compared to flat pin feet, the spherical cap shape is more flexible and can adjust to tilts of components such as chips, metal preforms, the flat plate structure, or other joining components, thereby improving the pressure distribution between the pin feet and the tilted components and enabling the use of rigid flat plate structures for current distribution.

According to an embodiment of the present invention, each of the plurality of electrical contacts may be a pressure contact and comprise a spring and/or a current carrying bracket surrounding the spring. Optionally, the spring and the bracket may be sleeved on the pin. Optionally, the flat plate structure may be sleeved on the pins and be arranged between the brackets and the pins of the plurality of electrical contacts.

In this design, the spring may maintain a consistent contact pressure during all operation modes of the power conducting module, while the electrically conducting brackets increase a cross-section area of the electrical contacts to provide or enhance the current-carrying capability of the module. Meanwhile, the spring and/or the bracket may be elastic and deformable to further compensate the mechanical tolerance during manufacturing and the thermal expansion during operation, thereby, improving the stability and long-term reliability of the power semiconductor module.

Optionally, the pin foot of each presspin body may comprise a through hole or an opening on the top surface of the pin foot. Each presspin body may further comprise a pin having a bottom part movably or flexibly accommodated in the through hole or the opening. The opening may be provided on the top surface of the pin foot. The through hole may be provided extending from the top surface to the bottom surface of the pin foot. That is, the pin and pin foot of each presspin body are connected to the pin foot in a flexible manner. The difference between the opening and the through hole is that the opening does not extend through the pin foot.

The flexible connection between the pin and the pin foot enables relative movement, especially relative tilt, between the pin and the pin foot and facilitate the compensation for mechanical tolerances during manufacturing and thermal expansion during operation, leading to more robust and durable electrical and mechanical connections.

In this embodiment where the pin foot comprises the through hole, the through hole may comprise two side openings on the top surface and the bottom surface of the pin foot, and an internal limiting section. A width or diameter of the internal limiting section is smaller than widths or diameters of the side openings. In other words, the through hole comprises a portion narrower than the openings on both surfaces. The internal limiting section may be configured to limit an axial movement of the pin flexibly connected to the pin foot. The internal limiting section can prevent detachment or loosening of the pin.

Moreover, in this design, it is possible to further increase sizes of the side openings and improve the tolerance compensation capability and mechanical robustness of the module. In particular, the possible tilting angle of the pin foot with respect to the pin can be increased by enlarging the diameter of the side openings on both the top and bottom surfaces of the pin foot with the internal limiting section. As a result, this facilitates the relative movement for compensating the mechanical tolerances and thermal expansion. Meanwhile, the risk of collision between the pin and the pin foot is further reduced, preventing potential damage and ensuring a reliable electrical connection.

Alternatively, in the embodiment where the pin foot comprises an opening on its top surface to accommodate the pin, the opening may also comprise an internal limiting section with a narrower inner diameter and/or inner width for limiting the detaching of the pin.

Optionally, an inner wall of the through hole may be tapered inward from the side openings to form the internal limiting section. In this design, the through hole may be realized by two conical openings extending from the top and the bottom surfaces of pin foot. As an alternative, the internal limiting section comprises a protrusion structure on the inner wall of the through hole. For example, the inner wall of the through hole may be protrude inwards circumferentially to form the internal limiting section.

The limiting section may be provided in the middle of the through hole. The limiting section may also be provided at other positions inside the through hole, closer to the top opening or the bottom opening.

According to an embodiment of the present invention, the bottom of each pin comprises a flange structure or a thickened structure, wherein a diameter or width of the flange structure or thickened structure is greater than the inner diameter or inner width of the internal limiting section. In this design, the bottom of the pin may protrude outward circumferentially to form the flange structure. Alternatively, the bottom of the pin may feature a protruding block to form the thickened structure. A portion of the bottom of the pin may protrudes outwardly to form the protruding block.

By incorporating the flange or the thickened structure, mechanical strength and connection reliability are enhanced, preventing the pin from being pulled out of the through hole under external forces.

In an alternative embodiment of the present invention, the pin and the pin foot of each presspin body may be fixedly connected. Preferably, the pin and the pin foot may be formed as an integrated component. An integrated structure reduces the number of separate components, simplifying the assembly process and enhancing mechanical stability. Additionally, this design may also reduce the electrical and thermal resistance of the electrically conducting elements.

According to an embodiment of the present invention, each pin foot may have a column-like shape and a horizontal cross-section in the form of a circle, an oval, a square, or a rectangle. The shape of the pin foot is not limited to the above-mentioned examples and may be determined based on practical requirements.

According to an embodiment of the present invention, the pin and or the pin foot may be made of an electrically conductive material. Preferably, the material may comprise, but is not limited to copper, aluminium, copper alloy or aluminium alloy.

Optionally, the pin and the pin foot may comprise a metal coating. Preferably, the material for the metal coating may include, but is not limited to, nickel, gold and silver. The metal coating may improve corrosion resistance, enhance conductivity, and facilitate reliable electrical connections over extended operational lifetimes.

According to an embodiment of the present invention, the flat plate structure may comprise a single-layered metal plate interconnecting all of the plurality of electrical contacts, a multi-layered structure comprising a stack of metal sheets each interconnecting all of the plurality of electrical contacts, or a multi-layered structure comprising a stack of electrically conducting elements each connecting at least a part of the plurality of electrical contacts. Different flat plate structures may be chosen based on the operational conditions and requirements of the power semiconductor module. A lateral dimension of the flat plate structure may be defined by a size of the power semiconductor module while a thickness of the flat plate structure may be determined according to the current carrying/withstand requirements of the module.

In case the multi-layered structure comprises a stack of electrically conducting elements, each electrically conducting element may connect to at least one of the electrical contacts while the complete multi-layered structure interconnecting all the electrical contacts. The multi-layered structure may further reduce the rigidity of the flat plate structure to enhance the mechanical tolerance compensation capability of the semiconductor module.

In an embodiment of the present invention, the flat plate structure may be made of a thermally and electrically conductive material. Preferably, the material may comprise but is not limited to copper, copper alloy, aluminium and/or aluminium alloy.

According to an embodiment of the present invention, the power semiconductor module may comprise a plurality of metal preforms. Each metal preform may be arranged on a contact surface of one of the plurality of power semiconductor devices facing the top plate. The bottom surface of each pin foot then abuts and is electrically connected to one of the plurality of metal preforms.

Here, metal preform refers to a metal layer or a metal plate preformed above the contact surface of the semiconductor device. The metal preforms may be formed on a top contact surface of each semiconductor device. Typically, the metal preforms may be made of molybdenum, aluminium, or other similar materials. Optionally, the plurality of metal preforms may be connected to the plurality of power semiconductor devices by soldering, sintering, or adhesive bonding.

Another aspect of the invention further provides a method for assembling the power semiconductor module according to any one of the previous claims, comprising the steps of:
attaching the plurality of semiconductor devices to the electrically conducting base plate,
interconnecting the plurality of electrical contacts with the multi-layered structure,
attaching the electrically conducting top plate to the plurality of electrical contacts, and
connecting the plurality of electrical contacts to the plurality of semiconductor devices.

The semiconductor devices can be attached to the base plate via soldering, sintering, adhesive bonding or other similar approaches.

Optionally, the step of connecting the plurality of electrical contacts may comprise aligning and connecting the plurality of electrical contacts to the plurality of semiconductor devices.

Optionally, the method may further comprise a step of attaching the plurality of metal preforms to the plurality of semiconductor devices. The metal preforms may be connected to the plurality of semiconductor devices via soldering, sintering or adhesive bonding.

Optionally, in case the pin and the pin foot are flexibly connected, the method may further comprise a step of assembling the plurality of electrical contacts by fixing the pins into corresponding pin feet.

### Brief description of drawings

These and other aspects of the invention will be apparent from and elucidated with reference to the implementations described hereinafter.

In the drawings:
Fig. 1 shows a front view cross sectional diagram of a prior art.
Fig. 2 shows a front view cross sectional diagram illustrating an unwanted situation.
Fig. 3 shows a front view diagram of an embodiment of a power semiconductor module with a flat plate structure and pin feet with spherical top surfaces.
Fig. 4 shows a front view diagram of another embodiment of the power semiconductor module with the flat plate structure and pin feet with spherical bottom surfaces.
Fig. 5 shows a front view diagram of another embodiment of the power semiconductor module with the flat plate structure, metal preforms and pin feet with spherical top surfaces.
Fig. 6 shows a front view cross sectional diagram illustrating an embodiment of a flexible connection between a pin and a pin foot according to of the present invention with the flat plate structure.
Fig. 7 shows a front view cross sectional diagram illustrating another embodiment of the flexible connection between the pin and the pin foot.
Fig. 8 shows a front view cross sectional diagram illustrating another embodiment of the flexible connection between the pin and the pin foot.
Fig. 9 shows a front view cross sectional diagram illustrating a through hole of the pin foot according to an embodiment of the present invention.
Fig. 10 shows a front view cross sectional diagram illustrating a through hole of the pin foot according to another embodiment of the present invention.
Fig. 11 shows a front view cross sectional diagram illustrating an embodiment of a fixed connection between a pin and a pin foot according to of the present invention.
Fig. 12 shows a front view cross sectional diagram illustrating another embodiment of the fixed connection between the pin and the pin foot according to of the present invention.
Fig. 13 shows a front view diagram of another embodiment of the power semiconductor module with a multi-layered structure and pin feet with spherical top surfaces.
Fig. 14 shows a flow chart according to an embodiment of a power semiconductor module assembling method.

### Description of implementations

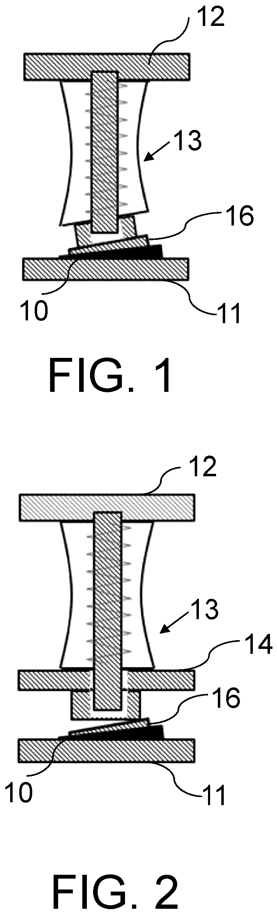

Fig. 1 shows a front-view cross-sectional diagram of part of a power semiconductor module according to the prior art. As shown in Fig. 1, a semiconductor device 10 is connected to a base plate 11 via a contact surface, with a metal preform 16 attached to another contact surface of the semiconductor device. A top plate 12 is then electrically connected to the semiconductor device 10 via an electrical contact 13 comprising a presspin body, a spring, and a bracket. The pin foot of the electrical contact 13 is pressed against the metal preform 16. The semiconductor device 10 may be connected to the base plate 11 by a soldering connection. The metal preform 16 may also be connected to the semiconductor device 10 by a soldering connection. Due to process tolerances, the metal preform 16 and the semiconductor device 10 in stack may have a certain tilt, such that the top surface of the metal preform 16 and the abutting surface of the pin foot are not parallel to each other. This tilt may be compensated by a corresponding movement of the pin foot. The mechanical and electrical contact between the pin foot and the current-carrying bracket is kept stable due to the flexible and spring-like behaviour of the bracket.

However, as shown in Fig. 2, when a robust and rigid distribution plate 14 is used, the described tilt compensation is no longer possible because of the flat top surface of the pin foot being in contact with the rigid flat bottom surface of the distributor plate 14, such that two parallel surfaces are arranged against each other under pressure, allowing no tilt. This leads to a smaller contact area, such as a point contact in an extreme case, between the pin foot and the metal preform 16 and consequently to strong pressure being locally applied to the metal preform 16 and the semiconductor device surface, such that the semiconductor device 10 may be damaged due to the strong mechanical impact.

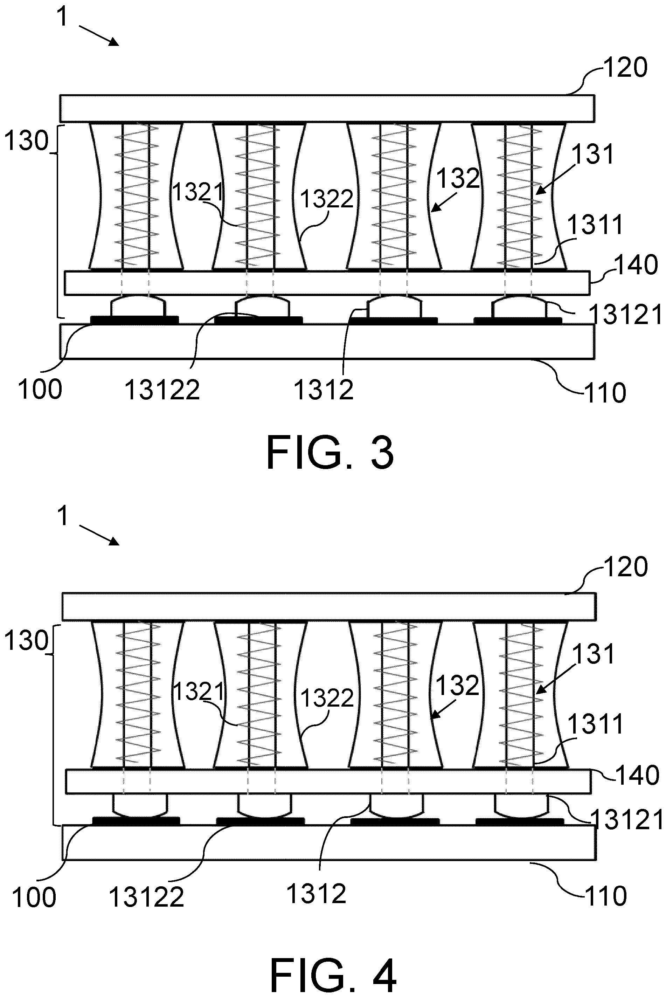

Fig. 3 shows a front view diagram of an embodiment of a power semiconductor module 1 with a flat plate structure 140 and pin feet 1312 with spherical top surfaces 13121 according to the present invention. The flat plate structure is configured as a distribution plate providing current and/or heat distribution during normal operation and critical situations like SCFM case.

Here, the semiconductor power module 1 refers to a functional unit of power applications. It can be combined with other semiconductor power modules, capacitors, and /or control circuitry, into a single package to handle power conversion, regulation, or switching at a system level. For different definition, the semiconductor power module may also refer to semiconductor power submodule, such as a semiconductor switching unit.

As shown in Fig. 3, the power semiconductor module 1 comprises an electrically conducting base plate 110 and an electrically conducting top plate 120 arranged in parallel to each other. A plurality of power semiconductor devices 100 are arranged on the base plate 110, facing the top plate 120, with a plurality of electrical contacts 130 electrically connecting the plurality of semiconductor devices 100 in parallel. Each electrical contact 130 is arranged between the top plate 120 and one of the plurality of power semiconductor devices 100 to establish an electrical connection. **The** power semiconductor module 1 further comprises a flat plate structure 140 mechanically, thermally and/or electrically interconnecting the plurality of electrical contacts 130. Each electrical contact 130 comprises a presspin body 131 with a pin foot 1312. The pin foot 1312 has a top surface 13121 abutting the flat plate structure 140 and a bottom surface 13122 facing one of the plurality of semiconductor devices 100. The top surface 13121 of each pin foot 1312 has a convex spherical cap shape.

The convex spherical cap shaped top surfaces eliminate the problem of two parallel surfaces being arranged against each other under pressure, allowing for compensation of the tilt of the semiconductor devices 10 and/or other components. As discussed above, the combination of the flat plate structure 140 and the pin feet 1312 with spherical cap surfaces prevents local stress concentrations and thereby ensuring contact reliability and mechanical stability in terms of mechanical tolerances while improving the current-carrying and heat dissipation capabilities of the power semiconductor module.

Fig. 4 shows a front view diagram of another embodiment of the power semiconductor module 1 with the flat plate structure 140 and pin feet 1312 with spherical bottom surfaces 13122. Different from the example illustrated in Fig. 3, the pin feet 1312 have flat top surfaces 13121 and convex spherical cap shaped bottom surfaces 13122. In this embodiment, the curvature of the spherical bottom surfaces13122 may be locally adjusted to the mechanical tolerance and thermal expansion and function to increase the contact area between the pin feet and the tilted semiconductor devices 100 so as to prevent localized strong pressure in individual semiconductor device 100 and improve the reliability of mechanical and electrical connections.

A curvature radius of the convex spherical cap shape may range between but is not limited to 50 to 300 mm. Preferably, the curvature radius may range between 100 to 200 mm.

Further, as shown in Fig. 3 and Fig. 4, the electrical contacts 130 may be pressure contacts. Each electrical contact 130 may further comprise a spring 1321 and/or a current carrying bracket 1322 surrounding the spring 1321. The spring 1321 and/or the bracket 1322 may be sleeved on the pin 1311. The flat plate structure 140 may also be sleeved on the pins 1311 between the bracket 1322 and the top surfaces 13121 of the pin feet 1312. Although not depicted in the figures, each electrical contact 130 may only comprise a current carrying bracket 1322 arranged above or sleeved on its pin 1311.Optionally, the spring 1321 may also be electrically conductive and may serve as a current-carrying element.

As shown in the Fig. 3 and Fig. 4, the plurality of electrical contacts 130 establishes electrical connections between the top plate 120 and the plurality of semiconductor devices 100 by directly connecting to top contact surfaces of the plurality of semiconductor devices 100.

Alternatively, the bottom surfaces 13122 of the plurality of electrical contacts 130 may not be connected directly to contact surfaces of the semiconductor devices 100 but may abut and be connected to the base plate 110 to establish parallel electrical connections between the semiconductor devices 100. In this case, the number of the electrical contacts 130 may not be equal to the number of the semiconductor devices 100 and may be determined according to needed current-carrying capability. The base plate 110 may be electrically connected to bottom contact surfaces of the plurality of semiconductor devices. Top ends of the electrical contacts 130 may be insulated from the top plate 120 or arranged in openings of the top plate 120 with a certain tolerance. The electrical contacts 130 may establish electrical connections between the plurality of semiconductor devices and other external terminals.

As another alternative, the bottom surfaces 13122 of the plurality of electrical contacts 130 may abut and be connected to a first metallization pattern. The first metallization pattern may be provided on an isolating layer made of resin or ceramics arranged on the base plate 110. The first metallization pattern may be electrically connected to the top contact surfaces of the plurality of semiconductor devices 100 so that the electrical contacts 130 can establish electrical connections between the top contact surfaces the plurality of semiconductor devices 100 and the top plate 120 or other external terminals.

Optionally, in this specific example, the bottom contact surfaces of the semiconductor devices may be connected to a second metallization pattern being isolated from the first metallization pattern.

Alternatively, the electrical contacts 130 may abut and electrically connect to the second metallization pattern to establish electrical connections between the bottom contact surfaces of the plurality of semiconductor devices and other external terminals or the top plate 120. In this alternative, the first metallization pattern is not connected to the plurality of electrical contacts 130 and is isolated from the second metallization pattern.

In addition, gate contact surfaces of the semiconductor devices 100 may be connected to a third metallization pattern being isolated from the first metallization pattern and the second metallization pattern. The third metallization pattern may be connected to other external terminals, such as gate terminals.

Specifically, when electrical connection is established between the semiconductor devices 100 and other external terminals, the top ends of the plurality of electrical contacts 130 may be insulated from the top plate 120 or arranged in openings of the top plate 120 with a certain tolerance.

The top contact surfaces of the plurality of semiconductor devices may be emitter areas, the bottom contact surfaces of the plurality of semiconductor devices may be collector areas and vice versa.

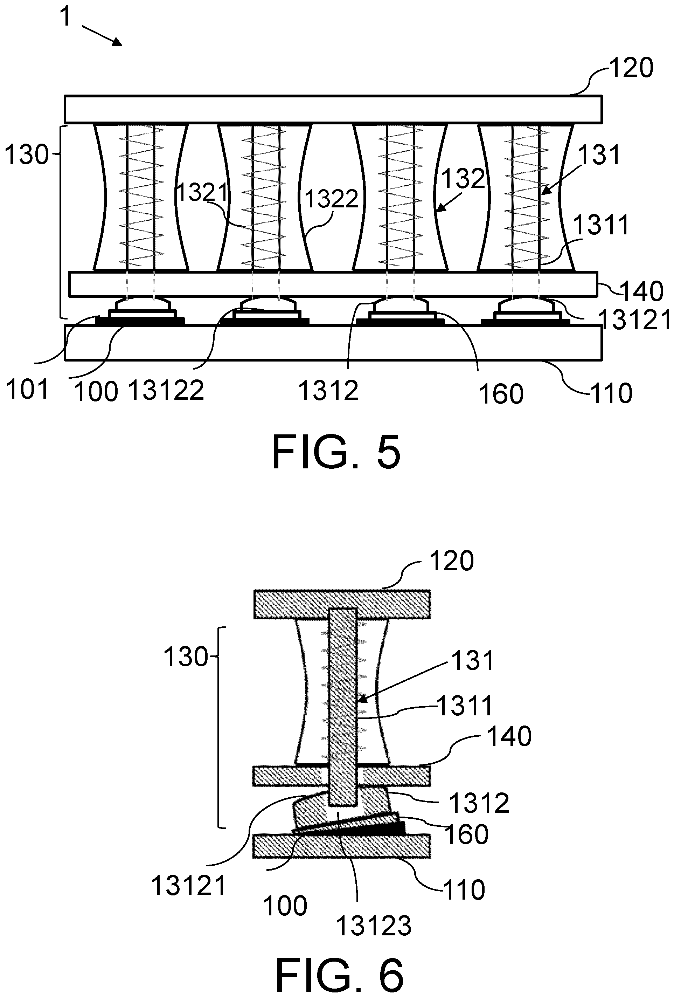

Fig. 5 shows a front view diagram of another embodiment of the power semiconductor module 1 with a flat plate structure 140 and the pin feet with spherical top surfaces. In addition to the example illustrated in Fig.3, the power semiconductor module 1 further comprises a plurality of metal preforms 160. Each metal preform 160 is arranged on the top contact surface 101 of one of the plurality of power semiconductor devices 100 facing the top plate 120. The bottom surface 13122 of each pin foot 13122 abuts and is electrically connected to one of the plurality of metal preforms 160. The top contact surface may be the collector area and the emitter area.

The dimensions of the metal preform 160 may be defined based on the size of the semiconductor device. Optionally, the metal preform may have a thickness ranging from 0.5 mm to 3 mm, but it is not limited to this range. The metal preform may have a square, rectangular, polygonal, or round shape and a horizontal width, length, or diameter of 7 mm to 20 mm, preferably 10 mm to 15 mm. **It** should be noted that the shape and dimensions of the metal preform are not limited to the above-mentioned embodiments. Typically, the metal preforms may be made of molybdenum, aluminium, or other applicable materials.

Although not depicted in Fig. 4, the embodiment with spherical bottom surfaces 13122 may also use metal preforms 160. Moreover, it is also possible for the pin feet 1312 to have both convex spherical cap shaped top surfaces 13121 and convex spherical cap shaped bottom surfaces 13122.

According to an embodiment of the present invention. Each presspin body 131 may comprise a pin 1311 that is flexibly connected to the pin foot 1312. Specifically, the pin foot 1312 of each presspin body 131 may comprise a through hole 13123 or an opening 13124 extending from the top surface 13121. A bottom part of the pin 1311 is then accommodated in the through hole 13123 or the opening 13124. Although the opening 13124 is not depicted in the figures, it should be noted that the only difference between the opening 13124 and the through hole 13123 is that the opening 13124 does not extend through the pin foot 1312 from its top surface 13121 to its bottom surface 13122.

Fig. 6 shows a front view cross sectional diagram illustrating an embodiment of a flexible connection between a pin and a pin foot according to of the present invention. For the purpose of clarification, Fig. 6 only shows the connection between one electrical contact 130 and one semiconductor device 1. As shown in Fig. 6, the pin foot 1312 may have a convex spherical cap shaped top surface 1312 and a through hole 13123 to accommodate the bottom part of the pin 1311. The flexible connection between the pin 1311 and the pin foot 1312 enables relative movement, especially angular movement, while the spherical top surface allows for motion in presence of the flat plate structure 140. Consequently, when the stack of the metal preform 160 and the semiconductor device 110 is tilted or mismatched due to thermal expansion, the pin foot 1312 may tilt relative to the pin 1311 and the flat plate structure 140 to ensure reliable contact between the bottom surface of the pin foot 1312 and the metal preform 160. It should be noted that the metal preform 160 is not essential and can be omitted.

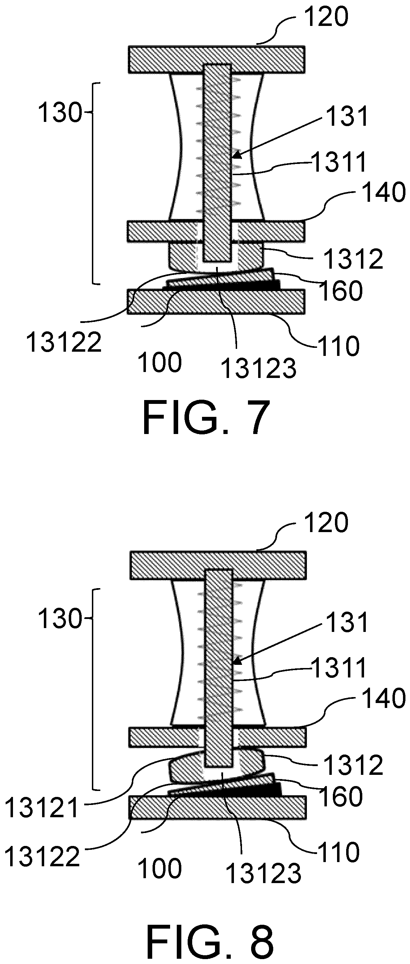

Fig. 7 shows a front-view cross-sectional diagram illustrating another embodiment of the flexible connection between the pin and the pin foot. Unlike the example illustrated in Fig. 6, the bottom surface 13122 of the pin foot 1312 may have a convex spherical cap shape. The curvature of the spherical bottom surface 13122 thereby increases the contact area between the pin foot 1312 and the tilted stack of the metal preform 160 and the semiconductor device 100, helping to prevent localized strong pressure on individual semiconductor devices and improve the reliability of mechanical and electrical connections. This design may also enhance the compensation of mechanical tolerances and thermal expansion. It should be noted that the metal preform 160 is not essential and can be omitted.

Fig. 8 shows a front-view cross-sectional diagram illustrating another embodiment of the flexible connection between the pin and the pin foot. In this example, the top surface 13121 and the bottom surface 13122 of the pin foot 1312 may both have a convex spherical shape. This design further increases the range of motion and may also facilitate the compensation of mechanical tolerances and thermal expansion. It should be noted that the metal preform 160 is not essential and can be omitted.

Although not depicted in the figures, the through holes 13123 illustrated in Fig. 6 to Fig. 8 can be replaced with corresponding openings 13124 that do not extend through the pin feet 1312.

In some embodiments, the through hole 13123 may include two side openings on the top surface 13121 and the bottom surface 13122 of the pin foot 1312, and an internal limiting section that is narrower than the side openings. In addition, the bottom of the pin 1311 may feature a flange structure or a thickened structure wider than the internal limiting section. The flange structure or the thickened structure cooperates with the internal limiting section to prevent the pin 1311 from being pulled out of the through hole13123 under external forces.

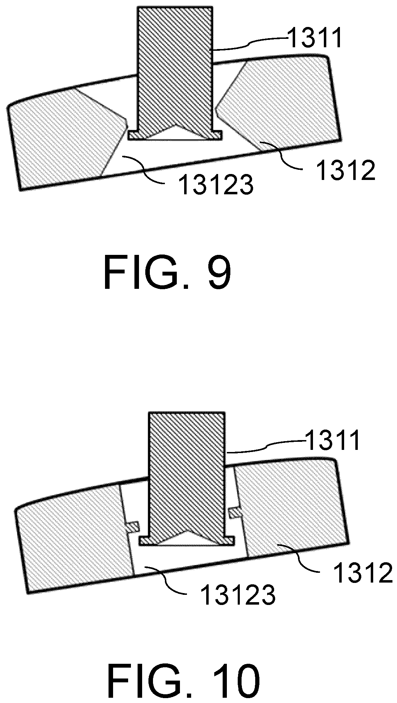

A combination of the internal limiting section and the flange structure or the thickened structure helps to prevent detachment between the pin 1311 and the pin foot 1312. Fig. 9 and Fig. 10 illustrate different examples of the through hole 13123. These designs allow for the motion of the pin 1311 to compensate mechanical tolerances and thermal expansion, while provide a certain fixation of the pin 1311 and the pin foot 1312.

As shown in Fig. 9, an inner wall of the through hole 13123 may be tapered inward from the side openings to form the internal limiting section that is narrower than the side openings. The bottom end of the pin 1311 may feature a protruding flange structure. The flange structure is wider than the internal limiting section so that the pin 1311 will not be pulled out of the through hole 13123 during assembling and operation.

Fig. 10 shows another example of the internal limiting section, where the inner wall of the through hole 13123 may feature a protruding stage as the internal limiting section. With the protruding stage, the internal limiting section may have an inner diameter narrower than the diameter of the flange structure and thus can limit the axial movement of the pin 1311 during assembling and operation. Alternatively, when the through hole does not have a round cross section, the internal limiting section formed by the protruding stage may have an inner length and an inner width narrower than the length and width of the flange structure.

Although not depicted in Fig. 9 and Fig. 10, instead of the circumferential flange structure, a portion in the bottom of the pin 1311 may extend outwardly to form a protruding block or protruding structure at the bottom of the pin 1311. Other designs of the thickened structure capable of preventing the pin 1311 from being pulled out of the through hole 13123 under external forces are also possible. Instead of the through hole 13123, the opening 13124 on the top surface 13121 that does not extend through the pin foot 1312 may also be applied. In this regard, the opening 13124 may only comprise one side opening at the top surface 13121 of the pin feet 1312 and the corresponding internal limiting structure as described above. The bottom surface 13122 of the pin feet 1312 may be a closed surface.

In addition, as shown in Fig. 9 and Fig. 10, the side opening on the top surface may be substantially wider than the pin 1311 so as to reduce the risk of collision between the pin 1311 and the pin foot 1312 and facilitate relative movement with respect to tilts and thermal expansions, thus, preventing potential damage and ensure a reliable electrical connection. The internal diameter of the side opening on the top surface may be 1.1 to 3 times wider than the diameter of the pin 1311.

It should be noted that although the internal limiting sections shown in Fig. 9 and Fig. 10 are provided in the middle of the through hole 13123. The limiting section may also be provided at other positions inside the through hole, closer to the top opening or the bottom opening.

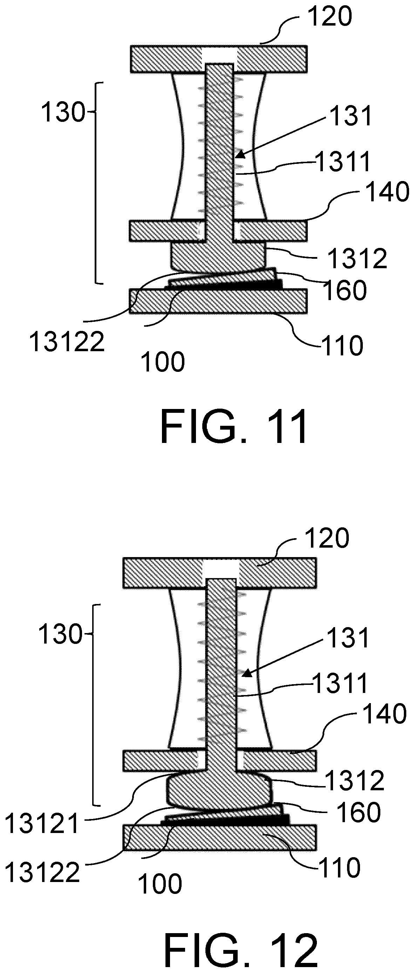

As an alternative design, the pin 1311 and the pin foot 1312 of each presspin body 131 may be fixedly connected to enhance mechanical stability and to reduce electrical and thermal resistance. Preferably, the pin 1311 and the pin foot 1312 may be formed as an integrated component. Fig. 11 and Fig. 12 show different examples in which the pin 1311 and the pin foot 1312 are formed as one component.

As illustrated in Fig. 11, the pin foot 1312 may have the flat top surface 13121 and the convex spherical cap shaped bottom surface 13122 to increase the contact area between the pin feet and the tilted stack of the metal preform 160 and the semiconductor device 100 and to improve the reliability of mechanical and electrical connections. In the alternative example shown in Fig.12, the pin foot 1312 may have both the convex spherical cap shaped top surface 13121 and the convex spherical cap shaped bottom surface 13122. As preferably depicted in Fig. 11 and Fig. 12, for fixed connection between the pin 1311 and the pin feet 1312, the top plate 130 may comprise corresponding through holes or openings to accommodate the pin. This may provide the pin more flexibility to tilt.

According to an embodiment of the present invention, each pin foot may have a column-like shape and a horizontal cross-section in the form of a circle, an oval, a square, or a rectangle. Optionally, each pin foot may have a horizontal width, length, or diameter ranging from 7 mm to 20 mm, preferably 10 mm to 15 mm. Each pin foot may have a height ranging from 2 mm to 10 mm, preferably 3 mm to 7 mm. The dimensions of the pin foot may also be smaller or larger. The shape and dimensions of the pin foot are not limited to the above-mentioned examples and may be determined based on practical requirements.

In addition, the pin 1311 and or the pin foot 1312 may be made of an electrically conductive material. Preferably, the material may comprise, but is not limited to copper, aluminium, copper alloy or aluminium alloy.

Optionally, although not depicted in the figures, the pin 1311 and the pin foot 1312 may comprise a metal coating. Preferably, the material for the metal coating may include, but is not limited to, nickel, gold and/or silver.

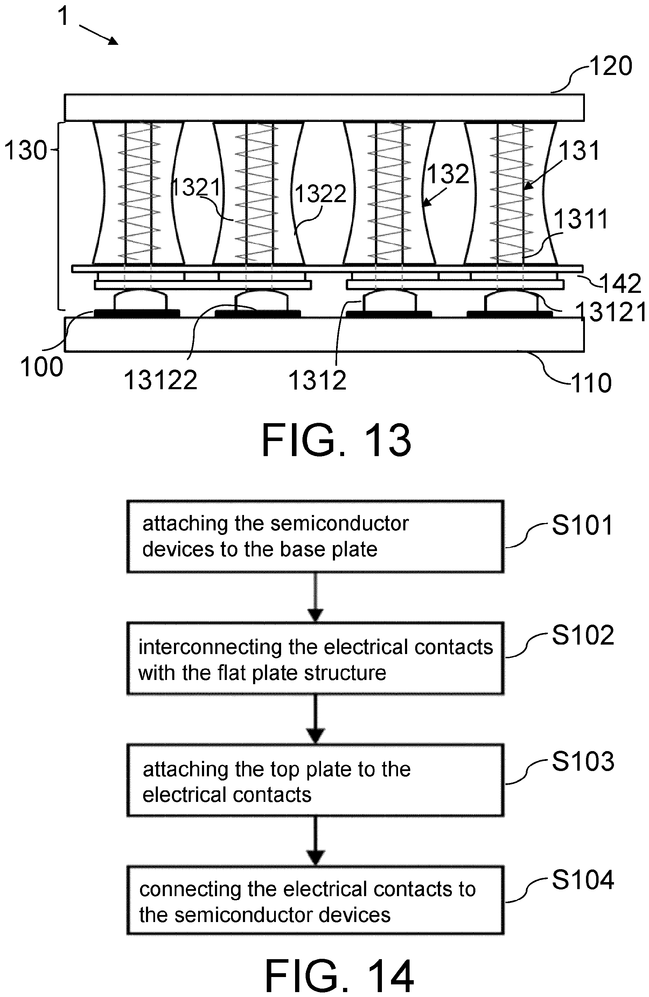

In some embodiments of the present invention, the configuration of the flat plate structure 140 may be different based on the operation conditions and requirements of the power semiconductor module 1. For example, the flat plate structure 140 may be chosen from a single-layered metal plate 141 interconnecting all of the plurality of electrical contacts 130, a multi-layered structure 142 comprising a stack of metal sheets 1421 each interconnecting all of the plurality of electrical contacts 130, or a multi-layered structure 142, as shown in Fig. 13, which comprises a stack of electrically conducting elements 1422 each connecting at least a part of the plurality of electrical contacts 130. The flat plate structure 140 may comprise through holes and may be sleeved on the pins 1311 of the plurality of electrical contacts 130.

Specifically, the lateral dimension of the flat plate structure 140 may be defined based on the size of the power semiconductor module 1. For example, the flat plate structure 140 may not be larger than the base plate 110 or the top plate 120. That is, the flat plate structure 140 may not extend beyond the outline of the base plate 110 or the top plate. The overall thickness of the flat plate structure 140 may be in a range of 1 mm to 15 mm. Preferably, the overall thickness may be in a range of 3 mm to 10 mm. Different thicknesses may also be considered based on practical requirements.

In addition, when the flat plate structure 140 comprises multiple layers, each layer may have a thickness in a range of 0.3 mm to 5 mm. Preferably, the thickness of each layer may be between 1 mm and 3 mm. Different thicknesses may also be considered based on practical requirements, and different layers may have different thicknesses. For the multi-layered structure 142 comprising a stack of metal sheets 1421, each metal sheet 1421 may constitute a layer and may interconnect all electrical contacts 130.

Fig. 13 shows a front-view diagram of another embodiment of the power semiconductor module 1 with a multi-layered structure 142 and pin feet 1312 with spherical top surfaces. Specifically, the multi-layered structure 142 comprises an upper layer consisting of a single electrically conducting element 1422 interconnecting all electrical contacts 130, a middle layer consisting of electrically conducting elements 1422 each connecting to only one electrical contact 130, and a bottom layer consisting of two electrically conducting elements 141 which connect a subset of the electrical contacts 130.It should be noted that the number and arrangement of the layers can vary and may be determined based on the operating conditions and requirements of the power semiconductor module 1.

Specifically, the electrically conducting elements 1422 may have different shapes and comprise a full plate interconnecting the plurality of electrical contacts 130, a partial plate interconnecting a subset of the plurality of electrical contacts 130, a full strip interconnecting all of the plurality of electrical contacts 130 that are arranged in a row, a partial strip interconnecting a subset of the plurality of electrical contacts 130 that are arranged in a row, and/or a washer connected to one of the electrical contacts 130.

The flat plate structure 140 may be made of a thermally and electrically conductive material. Preferably, the material may include, but is not limited to, copper, copper alloy, aluminium, or aluminium alloy.

In some specific embodiments, the electrical conductivity of the material may be higher than 15 MS/m, preferably higher than 25 MS/m. The thermal conductivity of the material may be higher than 120 W/m·K, preferably higher than 200 W/m·K. In addition, the material may have a melting point higher than the maximum temperature of the power semiconductor in the event of a short circuit.

Fig. 14 shows a flow chart according to an embodiment of a power semiconductor module assembling method. The method may be applied to assemble the power semiconductor modules 1 as described above. As shown in Fig. 14, the method comprises the step of:
S101: attaching the plurality of semiconductor devices 100 to the electrically conducting base plate 110,
S102: interconnecting the plurality of electrical contacts 130 with the multi-layered structure 140,
S103: attaching the electrically conducting top plate 120 to the plurality of electrical contacts 130, and
S104: connecting the plurality of electrical contacts 130 to the plurality of semiconductor devices 100.

Specifically, the semiconductor devices can be attached to the base plate via soldering, sintering, adhesive bonding or other applicable approaches. It should be noted that a temporal sequence of the steps S103 and S104 may be changed. In some preferred embodiments, the top plate 120 may be attached or mounted to the electrical contacts 130 after connecting the plurality of electrical contacts 130 to the plurality of semiconductor devices 100.

Optionally, the step of connecting (S104) the plurality of electrical contacts may comprise:
S1041: aligning and connecting the plurality of electrical contacts 130 to the plurality of semiconductor devices 100.

Optionally, when the electrical contacts 130 are pressure contacts, the method may further comprise:
S105: pressing the top plate 120 towards a direction to the plurality of semiconductor devices 100.

Optionally, when the power semiconductor module 1 applies metal preforms for enhanced SCFM capability or compensation of mismatch due to different thermal expansion coefficients, the method may further comprise the step of:
S1011: attaching the plurality of metal preforms to the plurality of semiconductor devices 100.

The metal preforms 160 may be connected to the semiconductor devices via soldering, sintering, adhesive bonding or other applicable approaches. And then the plurality of electrical contacts 130 may be aligned and connected to the corresponding metal preforms 160.

Optionally, in case the pin and the pin foot are flexibly connected. The method may further comprise the steps of:
S1012: assembling the plurality of electrical contacts 130 by fixing the pins 1311 into corresponding pin feet 1312.

While the invention has been illustrated and described in detail in the drawings and foregoing description, such illustration and description are to be considered illustrative or exemplary and not restrictive; the invention is not limited to the disclosed implementations. Other variations to be disclosed implementations can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

1 power semiconductor module
100 power semiconductor devices
101 contact surface
110 electrically conducting base plate
120 electrically conducting top plate
130 electrical contacts
131 presspin body
1311 pin
1312 pin foot
13121 top surface
13122 bottom surface
13123 through hole
13124 opening
1321 spring
1322 current-carrying bracket
140 flat plate structure
141 single-layered metal plate
142 multi-layered structure
1421 metal sheets
1422 electrical conducting elements
160 metal preforms

## Claims

1. A power semiconductor module (1) comprising:
an electrically conducting base plate (110) and an electrically conducting top plate (120) arranged parallel to each other,
a plurality of power semiconductor devices (100) arranged on the base plate (110) facing the top plate (120),
a plurality of electrical contacts (130) electrically connecting the plurality of semiconductor devices (100) in parallel, and
a flat plate structure (140) mechanically and/or electrically interconnecting the plurality of electrical contacts (130), wherein
each of the electrical contacts (130) comprises a presspin body (131) with a pin foot (1312) having a top surface (13121) abutting the flat plate structure (140) and a bottom surface (13122) facing the base plate (110),
the top surface (13121) and/or the bottom surface (13122) of each pin foot (1312) has a convex spherical cap shape.

2. The power semiconductor module (1) according to the previous claim, wherein
each of the plurality of electrical contacts (130) comprises a spring (1321) and/or a current carrying bracket (1322) surrounding the spring (1321).

3. The power semiconductor module (1) according to the previous claim, wherein the pin foot (1312) of each presspin body (131) comprises a through hole (13123) or an opening (13124) on the top surface (13121),
each presspin body (131) comprises a pin (1311) having a bottom part movably or flexibly accommodated in the through hole (13123) or the opening (13124).

4. The power semiconductor module (1) according to the previous claim, wherein
the through hole (13123) comprises two side openings on the top surface (13121) and the bottom surface (13122) of the pin foot (1312), and an internal limiting section,
an inner width or inner diameter of the internal limiting section is smaller than widths or diameters of the side openings.

5. The power semiconductor module (1) according to the previous claim, wherein
an inner wall of the through hole (13123) is tapered inward form the side openings to form the internal limiting section, or
the internal limiting section comprises a protrusion structure on the inner wall of the through hole (13123).

6. The power semiconductor module (1) according to any one of the previous two claims, wherein
a bottom of each pin (1311) comprises a flange structure or a thickened structure, wherein,
a diameter or a width of the flange structure or the thickened structure is greater than the inner diameter or inner width of the internal limiting section.

7. The power semiconductor module (1) according to the previous claim 1, wherein the pin (1311) and the pin foot (1312) of each presspin body (131) are fixedly connected,
preferably, formed as an integrated part.

8. The power semiconductor module (1) according to any one of the previous claims, wherein
each pin foot (1312) has a column-like shape and,
preferably, a horizontal cross-section in the form of a circle, an oval, a square or a rectangular.

9. The power semiconductor module (1) according to any one of the previous claims, wherein
the pin (1311) and/or the pin feet (1312) are made of an electrically conductive material, and/or
the material comprises preferably: copper, aluminium, copper alloy, or aluminium alloy.

10. The power semiconductor module (1) according to any one of the previous claims, wherein
the pin feet (1312) comprise a metal coating, preferably, a nickel coating, a gold coating or a silver coating.

11. The power semiconductor module (1) according to any one of the previous claims, wherein
the flat plate structure (140) comprises:
a single-layered metal plate (141) interconnecting all of the plurality of electrical contacts (130),
a multi-layered structure (142) comprising a stack of metal sheets (1421) each interconnecting all of the plurality of electrical contacts (130), or
a multi-layered structure (142) comprising a stack of electrical conducting elements (1422) each connecting at least a part of the plurality of electrical contacts (130).

12. The power semiconductor module (1) according to any one of the previous claims, wherein
the flat plate structure (140) is made of a thermally and electrically conductive material, and/or
the material comprises: copper, copper alloy, aluminium, and/or aluminium alloy.

13. The power semiconductor module (1) according to any one of the previous claims, further comprising
a plurality of metal preforms (160) each arranged on a contact surface (101) of one of the plurality of power semiconductor devices (100) facing the top plate (120), and
the bottom surface (13122) of each pin foot (13122) abuts and electrically connected to one of the plurality of metal preforms (160).

14. The power semiconductor module (1) according to the previous claim, wherein
the plurality of metal preforms (160) are connected to the plurality of power semiconductor devices (100) by soldering, sintering or adhesive bonding.

15. A method for assembling the power semiconductor module (1) according to any one of the previous claims, comprising the steps of:
attaching (S101) the plurality of semiconductor devices (100) to the electrically conducting base plate (110),
interconnecting (S102) the plurality of electrical contacts (130) with the flat plate structure (140),
attaching (S103) the electrically conducting top plate (120) to the plurality of electrical contacts (130), and
connecting (S104) the plurality of electrical contacts (130) to the plurality of semiconductor devices (100).
